# EUROPÄISCHE PATENTSCHRIFT

(11) **EP 2 559 785 B1**
(45) Veröffentlichungstag und Bekanntmachung des Hinweises auf die Patenterteilung: **12.10.2016**
(21) Anmeldenummer: 12180098.1
(22) Anmeldetag: 10.08.2012
(51) Int. Cl.: C23C 14/00, C23C 14/06, C23C 14/32, C23C 28/04

(54) **Beschichtung auf Basis von diamantähnlichem Kohlenstoff**
Coating on the basis of a diamond-like carbon based material
Revêtement à base de carbone semblable au diamant

(30) Priorität: 17.08.2011 US 201161573048 P
(43) Veröffentlichungstag der Anmeldung: 20.02.2013
(73) Patentinhaber: Fraunhofer-Gesellschaft zur Förderung der angewandten Forschung e.V., 80686 München (DE); Fraunhofer USA, Inc., Plymouth, MI 48170 (US)
(72) Erfinder: Scheibe, Hans-Joachim, 01309 Dresden (DE); Schuelke, Thomas, Brighton, MI 48116 (US); Haubold, Lars, East Lansing, MI 48823 (US); Becker, Michael, East Lansing, MI 48823 (US); Mahmut, Yaran, East Lansing, MI 48823 (US)
(74) Vertreter: Pfenning, Meinig & Partner mbB

(56) Entgegenhaltungen:
- DE-A1-102007 054 181
- DE-A1-102008 022 039
- JP-A- 2005 330 556
- US-A1- 2010 044 110
- US-B1- 6 468 642
- LIN Y H ET AL: "Modifying the properties of fluorinated amorphous films using argon by filtered cathodic vacuum arc", APPLIED SURFACE SCIENCE, ELSEVIER, AMSTERDAM, NL, Bd. 255, Nr. 5, 30. Dezember 2008 (2008-12-30), Seiten 2139-2142, XP025711753, ISSN: 0169-4332, DOI: 10.1016/J.APSUSC.2008.07.084 [gefunden am 2008-07-19]

## Beschreibung

Die Erfindung betrifft Beschichtungen auf Basis von diamantähnlichem Kohlenstoff, die auf unterschiedlichen Substraten ausgebildet sind und für verschiedene Schneid- und Gleitanwendungen eingesetzt werden können sowie ein Herstellungsverfahren.

So ist es seit langem bekannt, Substrate mit einer Beschichtung aus diamantähnlichem Kohlenstoff zu versehen. Solche Beschichtungen weisen eine hohe Härte und ein gutes Gleit- und Verschleißverhalten auf. Entsprechend beschichtete Substrate werden für die verschiedensten Anwendungen eingesetzt. Die Eigenschaften können durch Dotierungen und den Gehalt an Wasserstoff beeinflusst werden.

So ist es bekannt, dass das Gleitverhalten solcher Schichten durch eine Dotierung mit Fluor verbessert werden kann, da dies die Oberflächeneigenschaften positiv beeinflusst. So ist in US 6,468,642 B1 beschrieben, wie solche Schichten neben Fluor auch mit anderen chemischen Elementen, insbesondere zusätzlich mit Si, O und Wasserstoff dotiert sein können. Dadurch können die Schichteigenschaften weiter verändert und beeinflusst werden.

Für die Ausbildung solcher Schichten können geeignete Precursoren auf organischer Basis, in denen die chemischen Elemente enthalten sind, eingesetzt werden. Dabei ist aber die Verfahrensführung während der Beschichtung aufwändig und es ist schwierig die gewünschten Anteile der chemischen Elemente in der Beschichtung einzustellen.

Außerdem hat es sich herausgestellt, dass Schichten, die allein oder zusätzlich mit Fluor dotiert sind, zwar verbesserte Gleiteigenschaften aufweisen, was die Gleit- und auch die Haftreibung betrifft, aber diese vorteilhaften Eigenschaften lediglich über einen relativ kurzen Zeitraum erhalten bleiben und die Lebensdauer daher verschleißbedingt entsprechend verkürzt ist.

In der DE 2007 054 181 A1 ist eine korrosionsfeste Beschichtung beschrieben, bei der in Schichten neben Kohlenstoff auch Wasserstoff enthalten sein soll.

Die Schichten können zusätzlich mit einem Nichtmetall dotiert sein.

Bei der in DE 10 2008 022 039 A1 beschriebenen Verschleißschutzbeschichtung soll an Stelle von Wasserstoff, Sauerstoff in amorphem Kohlenstoff enthalten sein.

In der Schrift JP 2005330556 A ist eine Beschichtung auf Basis von diamantähnlichem Kohlenstoff mit Stapeln alternierender Kohlenstoffschichten mit und ohne Fluor nach dem Oberbegriff von Patentanspruch 1 offenbart.

Es ist daher Aufgabe der Erfindung, eine Beschichtung auf Substratoberflächen zur Verfügung zu stellen, die neben einer hohen Härte, einem guten Gleitverhalten auch eine vergrößerte Lebensdauer, bei Beibehaltung dieser positiven Eigenschaften, aufweisen bzw. erreichen.

Erfindungsgemäß wird diese Aufgabe mit einer Beschichtung, die die Merkmale des Anspruchs 1 aufweist, gelöst. Sie kann mit einem Verfahren nach Anspruch 10 hergestellt werden. Vorteilhafte Ausgestaltungen und Weiterbildungen der Erfindung können mit in untergeordneten Ansprüchen bezeichneten Merkmalen realisiert werden.

Die erfindungsgemäße Beschichtung auf Basis von diamantähnlichem Kohlenstoff ist aus mehreren alternierend übereinander ausgebildeten Schichten aus diamantähnlichem Kohlenstoff ausgebildet. Dabei sind jeweils eine Schicht in der kein oder nur ein deutlich geringerer Anteil an dotiertem Fluor enthalten ist, mit einer Schicht in der Fluor oder zumindest Fluor mit einem höheren Anteil als in der darunter oder darüber angeordneten Schicht enthalten ist, abwechselnd übereinander ausgebildet. Die Schichten ohne bzw. mit weniger Fluor wechseln sich also mit Schichten ab in denen Fluor oder mehr Fluor enthalten ist, ab, so dass ein entsprechendes Wechselschichtsystem auf der Oberfläche eines Substrats ausgebildet ist.

In Schichten mit Fluor oder einem erhöhten Anteil an Fluor, ist Fluor mit einem Anteil im Bereich 0,5 at-% bis 5 at-% enthalten. Bei diesen Schichten sollte der Anteil an Fluor vorteilhaft bei 1 ± 0,5 at-% gehalten sein. Demensprechend sollte der Anteil an Fluor in Schichten mit weniger Fluor in jedem Fall kleiner 0,5 at-% sein.

Schichten mit Fluor oder einem erhöhten Anteil an Fluor sollten eine kleinere Schichtdicke aufweisen, als Schichten in denen kein oder nur ein deutlich geringerer Anteil an dotiertem Fluor enthalten ist. Dadurch können die Härte, Festigkeit und die nutzbare Lebensdauer der erfindungsgemäßen Beschichtung weiter verbessert und die jeweiligen vorteilhaften Eigenschaften des reinen bzw. nahezu reinen diamantähnlichen Kohlenstoffs mit denen des mit Fluor dotierten Kohlenstoffs noch besser und vor allem länger ausgenutzt werden, da der Verschleiß gegenüber den nur mit Fluor dotierten Schichten aus diamantähnlichem Kohlenstoff verringert werden kann. Trotzdem lassen sich die durch Fluor verbesserten Oberflächeneigenschaften weiter gut nutzen.

In der erfindungsgemäßen Beschichtung sollten alle einzelnen Schichten jeweils eine Schichtdicke im Bereich 1 nm bis 100 nm aufweisen. Die Gesamtschichtdicke der Beschichtung ergibt sich dann aus der Summe der einzelnen übereinander ausgebildeten Schichten. Sie kann bei bis zu 20 µm liegen. Für bestimmte Anwendungen können aber auch deutlich geringere Gesamtschichtdicken ausreichen.

So kann bei einer Beschichtung mit mindestens zehn einzelnen übereinander ausgebildeten Schichten, die ein Minimum der Schichtanzahl darstellen sollte, eine Gesamtschichtdicke 0,1 µm, bei einer Einzelschichtdicke von jeweils 10 nm, erreicht werden.

Es hat sich herausgestellt, dass mit auf diesem Gebiet der Technik als ta-C bezeichneter diamantähnlicher Kohlenstoff besonders geeignet ist.

Vorteilhaft ist es außerdem, wenn zumindest einige der Schichten eine wellenförmige Oberfläche aufweisen. Dadurch bilden die einzelnen Schichten wellenförmige Erhebungen mit dazwischen angeordneten talförmigen Vertiefungen. Dies hat zur Folge, dass bei auftretendem Verschleiß, mit Werkstoffabtrag von der Oberfläche, an der Oberfläche der Beschichtung Bereiche entstehen, die mit Werkstoff der beiden Schichtarten gebildet sind, so dass sowohl die vorteilhaften Oberflächeneigenschaften, wie ein verbessertes Gleitverhalten, der mit Fluor dotierten Schichten, wie auch die erhöhte Verschleißfestigkeit der Schichten ohne Fluor bzw. mit sehr wenig Fluor zu jedem Zeitpunkt ausgenutzt werden können, auch wenn ein sukzessiver Werkstoffabtrag in Folge Verschleiß auftritt bzw. aufgetreten ist.

Dabei sollte sich die Welligkeit der Oberfläche von Schichten ausgehend von der Substratoberfläche bis zur Oberfläche der Beschichtung vergrößern.

In den Schichten ist kein Wasserstoff oder nur ein Anteil an Wasserstoff von maximal 0,05 at-% enthalten. Außerdem ist auch kein weiteres die Schichten dotierendes chemisches Element außer C und F, sowie ggf. ein sehr kleiner Anteil an S enthalten was einmal die Herstellung erleichtert und so die durch das dotierte Fluor verbesserten Oberflächeneigenschaften besser und einfacher ausgenutzt werden können. So kann insbesondere bei der Herstellung der Beschichtung mit einem PVD-Verfahren, worauf nachfolgend noch näher einzugehen sein wird, der jeweilige Fluoranteil einfacher, sicherer und genauer eingehalten werden. Schwefel kann bei Einsatz einer Schwefelverbindung als Precursor enthalten sein. Dabei liegt der Anteil an Schwefel in jedem Fall unterhalb 1 at-%, bevorzugt kleiner 0,5 at-%, besonders bevorzugt kleiner 0,2 at-%.

Als Substrat kann beispielsweise die Schneide eines Schneidwerkzeugs, insbesondere einer Rasierklinge oder ein Teil einer Gleitlagerung eingesetzt werden.

Eine erfindungsgemäße Beschichtung weist einen E-Modul im Bereich um 100 Pa und einen Wasserkontaktwinkel von 100° bis 120 ° auf. Es können Reibwerte kleiner 0,1 erreicht werden, die unterhalb des Reibwertes von reinem PTFE liegen.

Es besteht auch die Möglichkeit vor dem Aufbringen der Beschichtung auf der Oberfläche, eine insbesondere die Haftung verbessernde Zwischenschicht aufzubringen, auf der dann die Beschichtung mit den einzelnen Schichten sukzessive ausgebildet wird. Für die Zwischenschicht kann beispielsweise Cr, Ti, Ta, Nb, W, Zr oder Hf eingesetzt werden.

Bei der Herstellung kann so vorgegangen werden, dass bei Einsatz eines Targets aus reinem Kohlenstoff/Graphit mittels eines PVD-Verfahrens auf einer Oberfläche eines Substrates Schichten abgeschieden werden, wobei durch Veränderung eines zugeführten Volumenstroms einer Fluor-Kohlenstoffverbindung oder Schwefel-Fluorverbindung, als Precursor, der Anteil an in alternierend auszubildenden Schichten in dotierter Form enthaltenem Fluor verändert wird.

Dabei kann der Anteil innerhalb jeweils einer Schicht durch die Zufuhr des Precursors zusätzlich verändert werden, so dass der Anteil an Fluor sich von Schicht zu Schicht nicht sprunghaft ändern muss, sondern der Anteil innerhalb von mit Fluor dotierten Schichten ausgehend in Schichtaufwachsrichtung erst ansteigt und nach Erreichen eines Maximums dann wieder abfallen kann. Der zugeführte Volumenstrom des Precursors kann dementsprechend geregelt werden.

Besonders vorteilhaft ist es, die Beschichtung mittels eines Bogenentladungsverfahrens auszubilden. Dabei kann das Target als Kathode geschaltet sein. Es kann sich um ein Verfahren handeln, bei dem eine elektrische Bogenentladung zur Plasmabildung genutzt wird, die zwischen einer Anode und dem Target gezündet worden ist. Die Ausbildung kann aber auch mit dem so genannten Laser-Arc-Verfahren erfolgen, bei der ebenfalls elektrische Bogenentladungen zur Plasmabildung und Beschichtung genutzt werden. Diese werden aber intermittierend mittels eines auf ein Target an wechselnde Positionen gerichteten Laserstrahls gezündet und verlöschen nach einer bestimmten Zeit wieder, bevor ein erneutes Zünden an einer anderen Position mittels des Laserstrahls, der entsprechend ausgelenkt worden ist, erfolgt. Dadurch kann ein gleichmäßiger für die Beschichtung nutzbarer Werkstoffabtrag am Target erreicht werden, wodurch eine verbesserte Ausnutzung des Targetwerkstoffs und auch eine gleichmäßigere Schichtausbildung erreicht werden kann.

Während der Ausbildung der Beschichtung sollte ein inertes Gas, insbesondere Argon, mit einem Partialdruck von 0,1 Pa bis 0,5 Pa zugeführt werden. In Phasen in denen ein Precursor für die Fluordotierung zugeführt wird, steigt der Partialdruck innerhalb einer Vakuumkammer um einen Betrag an, der im Bereich 0,2 Pa bis 1 Pa liegt. Er wird durch den dann in Gasform vorliegenden Fluor enthaltenden Precusor erhöht. Sollte ein flüssiger Precursor eingesetzt werden, kann dieser innerhalb der Vakuumkammer verdampfen und in seine einzelnen chemischen Elemente rekombiniert werden, so dass elementares Fluor und Kohlenstoff vorliegen, die für die Schichtbildung ausgenutzt werden können. Die Rekombination kann dabei innerhalb des gebildeten Plasmas erfolgen.

Die Zufuhr eines Precursors kann intermittierend immer dann erfolgen, wenn eine mit Fluor dotierte Schicht der Beschichtung ausgebildet werden soll. In Phasen, in denen eine nicht oder wenig dotierte Schicht ausgebildet werden soll, kann die Precursorzufuhr gesperrt werden.

Als Precursor können beispielsweise CₓF_{y}, SF₆ oder CHFₓ, bevorzugt CHF₃ eingesetzt werden.

Der zugeführte Volumenstrom kann beispielsweise nach dem Öffnen eines Ventils sprunghaft ansteigen und dann auf einem bestimmten Wert über eine bestimmte Zeit gehalten werden. Es kann aber auch eine gesteuerte Zufuhr des Precursors über die Zeit erfolgen, bei der der Volumenstrom entsprechend an- und wieder absteigen kann.

Inertes Gas und/oder der Precursor können durch ein poröses Element, insbesondere ein poröses Target aus Kohlenstoff, zugeführt werden. Dadurch kann der zugführte Volumenstrom innerhalb der Vakuumkammer und insbesondere innerhalb des gebildeten Plasmas besser vergleichmäßigt werden, was sowohl die Verteilung der Volumenanteile, wie auch die zeitliche Freigabe betrifft. Eine Möglichkeit zur Zuführung durch ein poröses Target ist in der DE 198 50 217 C1 beschrieben. Auf einen solchen Aufbau und die darin beschriebene Verfahrensweise kann bei der Herstellung der erfindungsgemäßen Beschichtung zurück gegriffen werden.

Das mit einer erfindungsgemäßen Beschichtung versehene Substrat ist korrosionsbeständig und kann in aggressiver Umgebung betrieben werden. Es ist ein Einsatz unter Vakuumbedingungen, also auch im Weltraum möglich. Es sind keine die Umwelt, Lebensmittel oder die Physiognomie von Lebewesen beeinträchtigenden Komponenten oder Materialien enthalten. Die Beschichtung kann ohne Weiteres in Hautkontakt von Lebewesen gebracht werden, was insbesondere beim Einsatz für Rasierklingen vorteilhaft ist.

Nachfolgend soll die Erfindung beispielhaft näher erläutert werden.

Dabei zeigen:
- Figur 1: ein Schliffbild eines Beispiels einer erfindungsgemäßen Beschichtung mit einer auf der Substratoberfläche ausgebildeten Zwischenschicht aus Cr;
- Figur 2: ein Diagramm des ermittelten Reibkoeffizienten einer aus zehn einzelnen Schichten gebildeten Beschichtung mit jeweils einer Schichtdicke von 10 nm bei Kontaktreibung auf Stahl 105CrM17, trocken ohne Schmiermittel, der mit einem Fretting-Tribometer über den zurück gelegten Gleitweg ermittelt worden ist. Der Anteil an Fluor lag dabei in den mit Fluor dotierten ta-C-Schichten bei 1 at-%, die anderen Schichten waren ausschließlich aus ta-C gebildet;
- Figur 3: ein Vergleichsdiagramm mit einem Verlauf des Reibkoeffizienten, der mit einer einzelnen mit Fluor dotierten ta-C-Schicht unter den gleichen Bedingungen ermittelt worden ist und
- Figur 4: ein Vergleichsdiagramm mit einem Verlauf des Reibkoeffizienten analog zu Figur 2 ermittelt, wobei eine mit PTFE beschichtete Oberfläche auf der Stahloberfläche gleitend beansprucht wurde.

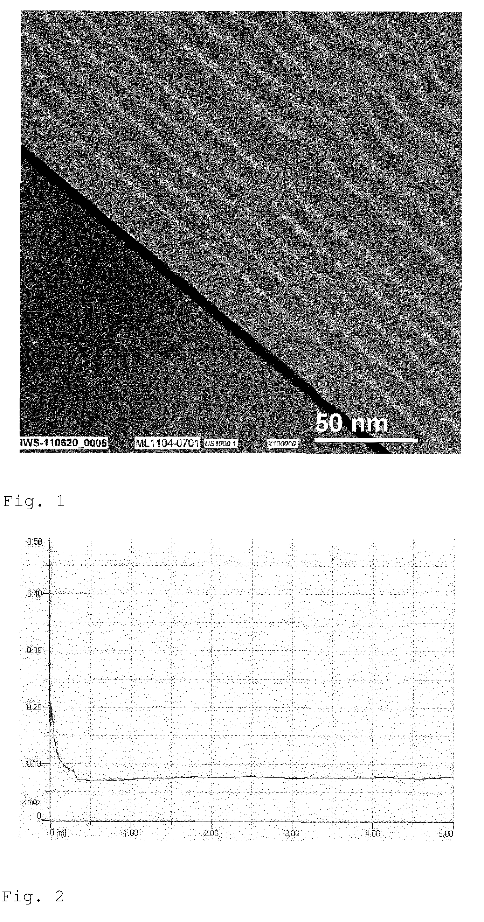

Es wird mit Figur 1 deutlich, dass mehrere einzelne Schichten übereinander auf einer Substratoberfläche und dann auf einer Zwischenschicht (schwarz erkennbar) ausgebildet worden sind. Dabei sind die heller dargestellten Bereiche der Beschichtung, Bereiche mit erhöhtem Anteil an Fluor. Es ist außerdem erkennbar, dass die einzelnen Schichten teilweise wellenförmig ausgebildet sind und dies besonders mit steigendem Abstand zur Substratoberfläche der Fall ist, wobei sich in diese Richtung auch die Welligkeit der Schichten erhöht.

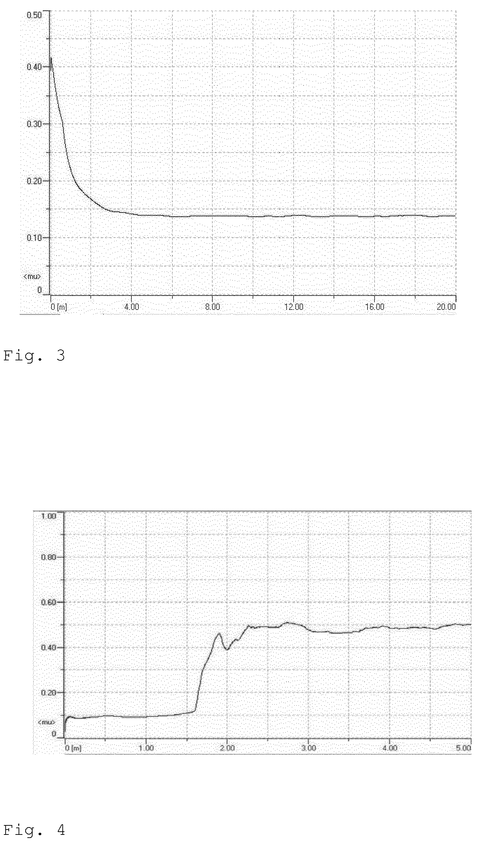

Mit den in den Figuren 2 bis 4 gezeigten Diagrammen wird deutlich, dass sich das Reibverhalten einer erfindungsgemäßen Beschichtung ähnlich, wie eine Schicht, die aus Fluor dotiertem ta-C gebildet ist, verhält. Nach einer kurzen Einlaufphase fällt der Reibkoeffizient auf einen nahezu konstanten Wert ab, den er über einen längeren Zeitraum einhält. Dabei erreichte die erfindungsgemäße Beschichtung einen Reibkoeffizienten von 0,075, wohingegen der Reibkoeffizient der Einzelschicht bei 0,14 lag, also doch beträchtlich höher liegt. Aus den Diagrammen von Figur 2 und 3 wird leider nicht deutlich, dass der Reibkoeffizient einer erfindungsgemäßen Beschichtung über einen längeren Zeitraum und Reibweg auf diesem niedrigen Wert gehalten werden kann, als dies bei der einen ta-C-Einzelschicht mit Fluor erreichbar war.

Aus dem in Figur 4 gezeigten Diagramm wird deutlich, dass eine PTFE-Beschichtung bereits nach kurzer Nutzung einen erheblichen Anstieg des Reibkoeffizienten zeigt, was auf sehr hohen Verschleiß schließen lässt und eine sehr geringe Lebensdauer zur Folge hat.

An einem Beispiel soll jetzt nachfolgend die Herstellung eines Beispiels einer erfindungsgemäßen Beschichtung detailliert beschrieben werden.

Ein Substrat aus Edelstahl wird senkrecht zur Plasmaquelle flach auf einem Substrathalter angebracht. Die Plasmaquelle ist mit einem als Kathode geschalteten Target gebildet, das aus einem zylinderförmigen Körper aus Graphit gebildet ist. In einem Abstand zum Target ist eine Anode angeordnet. Zwischen Target und Anode werden bei angelegter elektrischer Gleichspannung mittels eines Laserstrahls, der auf wechselnde Positionen der Oberfläche des Targets gerichtet wird, elektrische Bogenentladungen gepulst gezündet.

Das Substrat kann dabei stationär in Bezug zu Target und Anode angeordnet sein. Es besteht aber auch die Möglichkeit das Substrat mittels rotierender Bewegung zu beschichten.

Die Vakuumkammer in der die Beschichtung durchgeführt wird, wird auf einen Basisdruck von 10-3 Pa evakuiert und in der Vakuumkammer ein Partialdruck von 0.1 Pa mit Argon eingestellt.

Als erstes wurde eine Zwischenschicht auf der Substratoberfläche aus Chrom-oder Chrom-Kohlenstoff, als Haftschicht durch Gleichstrom-Kathodenzerstäubung ausgebildet, bevor auf dem Substrat die Beschichtung mit den alternierend angeordneten ausgebildeten Schichten ausgebildet wird. Diese Haftschicht hat eine Dicke von maximal 15 nm.

Die Beschichtung mit den alternierend übereinander ausgebildet Schichten wird dann bei einer Zufuhr Von 50 sccm - 150 sccm Argon durchgeführt und der Argonpartialdruck im Bereich 0,2 Pa -0,6 Pa gehalten, während die eingangs beschriebenen elektrischen Bogenentladungen zwischen Target und Anode mit einem konstanten elektrischen Strom von 1000 A mit einer Pulsfrequenz von 500 Hz gezündet und betrieben wurden.

Dabei erfolgte regelmäßig ein abwechselndes Ein- und Auslassen von 40 sccm - 50 sccm SF6 mit einem Partialdruck zwischen 0,5 Pa -1,0 Pa. Hierbei können die Ein- und Auslassintervalle des SF6 als Precursor in konstanten Zeitabständen, z.B. 10 s oder nach einer vorgegebenen Anzahl der gepulst betriebenen elektrischen Bogenentladungen, z.B. 30.000 gewählt werden. Bei einem sich in das mit den elektrischen Bogenentladungen gebildete Plasma hinein und wieder heraus drehenden Substrat, kann auch die Anzahl der Plasma-Durchfahrten (z.B. 1 Rotation) und dabei auch die Rotationsgeschwindigkeit die Dicken der einzelnen Schichten der Beschichtung beeinflussen.

So konnten bei einer Zufuhr von SF₆ mit einem Zeitabstand von 100 s bei einer Zeitdauer der Zufuhr von 30 s eine Schichtdicke von 3 nm, bei einem stationär angeordneten Substrat, für Schichten in denen Fluor enthalten war erhalten werden. Die Schichten, in denen kein oder ein deutlich geringerer Fluoranteil enthalten war, hatten dabei eine Schichtdicke von 36 nm.

Wurde das zu beschichtende Substrat bei der Beschichtung bewegt und es mit einer Geschwindigkeit von 1 m/min durch das mittels der elektrischen Bogenentladung gebildete Plasma hindurch bewegt, konnte bei einer Zufuhr von SF₆ als Precursor eine Schichtdicke von 2 nm bei einmaliger Bewegung durch das Plasma erreicht werden. In einer solchen Schicht war dann Fluor enthalten. Bei einem ebenso bewegten Substrat für die Ausbildung von Schichten in denen kein oder ein deutlich geringerer Fluoranteil enthalten war, konnte dabei eine Schichtdicke von 8 nm bei einmaliger Bewegung durch das Plasma erreicht werden. Ein Substrat kann dabei rotierend bewegt werden.

## Patentansprüche

1. Beschichtung auf Basis von diamantähnlichem Kohlenstoff, die auf einem Substrat ausgebildet ist,
wobei die Beschichtung aus mehreren alternierend übereinander ausgebildeten Schichten aus diamantähnlichem Kohlenstoff ausgebildet ist und dabei
eine Schicht in der kein oder nur ein deutlich geringerer Anteil an dotiertem Fluor enthalten ist, mit einer Schicht in der Fluor oder zumindest Fluor mit einem höheren Anteil als in der darunter oder darüber angeordneten Schicht enthalten ist, abwechselnd übereinander ausgebildet sind; und in Schichten mit Fluor oder einem erhöhten Anteil an Fluor, Fluor mit einem Anteil im Bereich 0,5 at-% bis 5 at-% enthalten ist,
**dadurch gekennzeichnet, dass**
in den Schichten kein Wasserstoff oder nur ein Anteil an Wasserstoff von maximal 0,05 at-% sowie kein weiteres die Schichten dotierendes chemisches Element außer S mit einem Anteil unterhalb 1 at-% enthalten ist.

2. Beschichtung nach Anspruch 1, **dadurch gekennzeichnet, dass** in Schichten mit Fluor oder einem erhöhten Anteil an Fluor, Fluor mit einem Anteil 1 ± 0,5 at-% enthalten ist.

3. Beschichtung nach Anspruch 1 oder 2, **dadurch gekennzeichnet, dass** Schichten mit Fluor oder einem erhöhten Anteil an Fluor eine kleinere Schichtdicke aufweisen, als Schichten in denen kein oder nur ein deutlich geringerer Anteil an dotiertem Fluor enthalten ist.

4. Beschichtung nacheinem der vorhergehenden Ansprüche, **dadurch gekennzeichnet, dass** alle Schichten jeweils eine Schichtdicke im Bereich 1 nm bis 100 nm aufweisen.

5. Beschichtung nach einem der vorhergehenden Ansprüche, **dadurch gekennzeichnet, dass** die Beschichtung mit mindestens zwei einzelnen übereinander ausgebildeten Schichten gebildet ist.

6. Beschichtung nach einem der vorhergehenden Ansprüche, dass alle Schichten mit ta-C, als diamantähnlichem Kohlenstoff gebildet sind.

7. Beschichtung nach einem der vorhergehenden Ansprüche,
**dadurch gekennzeichnet, dass** zumindest einige der Schichten eine wellenförmige Oberfläche aufweisen.

8. Beschichtung nach Anspruch 7, **dadurch gekennzeichnet, dass** sich die Welligkeit der Oberfläche von Schichten ausgehend von der Substratoberfläche bis zur Oberfläche der Beschichtung vergrößert.

9. Beschichtung nach einem der vorhergehenden Ansprüche, **dadurch gekennzeichnet, dass** das Substrat die Schneide eines Schneidwerkzeugs, insbesondere einer Rasierklinge oder ein Teil einer Gleitlagerung ist.

10. Verfahren zur Herstellung einer Beschichtung auf Basis von diamantähnlichem Kohlenstoff nach einem der vorhergehenden Ansprüche, bei dem unter Einsatz eines Targets aus reinem Kohlenstoff mittels eines PVD-Verfahrens auf einer Oberfläche eines Substrates Schichten abgeschieden werden, wobei durch Veränderung eines zugeführten Volumenstroms einer Fluor-Kohlenstoffverbindung oder einer Schwefel-Fluorverbindung, als Precursor, der Anteil an in alternierend auszubildenden Schichten in dotierter Form enthaltenem Fluor verändert wird; wobei
in Phasen in denen ein Precursor zugeführt wird, der Partialdruck innerhalb einer Vakuumkammer um einen Betrag ansteigt, der im Bereich 0,2 Pa bis 1 Pa liegt.

11. Verfahren nach Anspruch 10, **dadurch gekennzeichnet, dass** die Beschichtung mittels eines Bogenentladungsverfahrens ausgebildet wird.

12. Verfahren nach Anspruch 10 oder 11, **dadurch gekennzeichnet, dass** während der Ausbildung der Beschichtung ein inertes Gas, insbesondere Argon, mit einem Partialdruck von 0,1 Pa bis 0,5 Pa zugeführt wird.

13. Verfahren nach einem der Ansprüche 10 bis 12, **dadurch gekennzeichnet, dass** CₓF_{y}, SF₆ oder CHFₓ als Precursor eingesetzt wird.

14. Verfahren nach einem der Ansprüche 10 bis 13, **dadurch gekennzeichnet, dass** das inerte Gas und/oder der Precursor durch ein poröses Element, insbesondere ein poröses Target aus Kohlenstoff, zugeführt wird/werden.

## Claims

1. A coating based on diamond-like carbon which is formed on a substrate, wherein
the coating is formed from a plurality of films of diamond-like carbon formed alternatingly over one another and in this respect a film in which no portion or only a much lower portion of doped fluorine is contained and a film in which fluorine or at least fluorine with a higher portion than the film arranged thereunder or thereabove are formed alternatingly over one another, and
fluorine having a portion in the range of 0.5 at-% to 5 at-% is contained in films comprising fluorine or an increased portion of fluorine, **characterized in that**
no hydrogen or only a portion of hydrogen of a maximum of 0.05 at-% as well as no further chemical element doping is contained in the films, with the exception of S with a portion below 1 at-%.

2. A coating according to claim 1,
**characterized in that**
fluorine having a portion of 1 ± 0.5 at-% is contained in films comprising fluorine or comprising an increased portion of fluorine.

3. A coating according to claim 1 or 2,
**characterized in that**
films comprising fluorine or comprising an increased portion of fluorine have a smaller film thickness than films in which no portion or only a much lower portion of doped fluorine is contained.

4. A coating according to one of the preceding claims,
**characterized in that**
all films each have a film thickness in the range of 1 nm to 100 nm.

5. A coating according to one of the preceding claims,
**characterized in that**
the coating is formed with at least two individual films formed over one another.

6. A coating according to one of the preceding claims,
**characterized in that**
all films all films are formed with ta-C as a diamond-like carbon.

7. A coating according to one of the preceding claims,
**characterized in that**
at least some of the films have a wave-like surface.

8. A coating according to claim 7,
**characterized in that**
the waviness of the surface of the films increases starting from the substrate surface up to the surface of the coating.

9. A coating according to one of the preceding claims,
**characterized in that**
the substrate is the blade of a cutting tool, in particular of a razor blade or a part of a slide bearing.

10. A method for manufacturing a coating based on diamond-like carbon according to one of the preceding claims, wherein when a target of pure carbon is used, films are deposited on a surface of a substrate by means of a PVD process, with the portion of fluorine contained in doped form in films to be formed alternately being varied by varying a supplied volume flow of a fluorine/carbon compound or sulphur/fluorine compound as a precursor; wherein
in phases in which a precursor is supplied, the partial pressure within a vacuum chamber increases by an amount which lies in the range from 0.2 Pa to 1 Pa.

11. Method according to claim 10,
**characterized in that**
the coating is formed by means of an arc discharge process.

12. Method according to claim 10 or 11,
**characterized in that**
an inert gas, in particular argon, is supplied at a partial pressure of 0.1 Pa to 0.5 Pa during the forming of the coating.

13. Method according to one of the claims 10 to 12,
**characterized in that**
CₓF_{y}, SF₆ or CHFₓ is employed as a precursor.

14. Method according to one of the claims 10 to 13,
**characterized in that**
the inert gas and/or the precursor is/are supplied by a porous element, in particular a porous target of carbon.

## Revendications

1. Revêtement à base de carbone sous forme de diamant amorphe, qui est réalisé sur un substrat, le revêtement étant constitué de plusieurs couches, réalisées en alternance les unes au-dessus des autres, en un carbone sous forme de diamant amorphe, et une couche, qui ne contient pas ou ne contient qu'une proportion nettement plus faible de fluor dopé, étant disposée, en alternance l'une sur l'autre avec une couche qui contient du fluor ou au moins un fluor en une proportion plus grande que dans la couche disposée en-dessous ou au-dessus ; et, dans les couches contenant du fluor ou une proportion élevée de fluor, le fluor étant présent selon une proportion comprise entre 0,5 % en atomes à 5 % en atomes, **caractérisé en ce que** les couches ne contiennent pas d'hydrogène, ou ne contiennent qu'une proportion d'hydrogène au maximum de 0,05 % en atomes, et de même ne contiennent pas d'autre élément chimique, qui dope les couches, autre que S, présentant une proportion inférieure à 1 % en atomes.

2. Revêtement selon la revendication 1, **caractérisé en ce que** les couches contenant du fluor ou une proportion élevée de fluor contiennent du fluor selon une proportion de 1 ± 0,5 % en atomes.

3. Revêtement selon la revendication 1 ou 2, **caractérisé en ce que** les couches contenant du fluor ou une proportion élevée de fluor présentent une épaisseur de couche plus petite que les couches qui ne contiennent pas de fluor ou qui ne contiennent qu'une proportion nettement plus faible de fluor dopé.

4. Revêtement selon l'une des revendications précédentes, **caractérisé en ce que** toutes les couches présentent chacune une épaisseur de couche comprise dans la plage de 1 nm à 100 nm.

5. Revêtement selon l'une des revendications précédentes, **caractérisé en ce que** le revêtement est formé d'au moins deux couches individuelles, réalisées l'une au-dessus de l'autre.

6. Revêtement selon l'une des revendications précédentes, **caractérisé en ce que** toutes les couches sont formées avec du Ta-C en tant que carbone sous forme de diamant amorphe.

7. Revêtement selon l'une des revendications précédentes, **caractérisé en ce qu'**au moins quelques-unes des couches présentent une surface ondulée.

8. Revêtement selon la revendication 7, **caractérisé en ce que** l'ondulation de la surface des couches augmente, de la surface du substrat vers la surface du revêtement.

9. Revêtement selon l'une des revendications précédentes, **caractérisé en ce que** le substrat est l'arête tranchante d'un outil tranchant, en particulier une lame de rasoir ou une partie d'un palier lisse.

10. Procédé de fabrication d'un revêtement à base de carbone sous forme de diamant amorphe selon l'une des revendications précédentes, dans lequel, par utilisation d'une cible en carbone pur, on dépose des couches sur une surface d'un substrat par un procédé PVD, auquel cas, par modification d'un débit volumique amené d'un composé fluor-carbone ou d'un composé soufre-fluor servant de précurseur, on modifie la proportion de fluor contenue sous forme dopée dans des couches devant être réalisées en alternance ; la pression partielle à l'intérieur d'une chambre à vide subissant, dans les phases dans lesquelles un précurseur est amené, une augmentation d'une valeur comprise dans la plage de 0,2 Pa à 1 Pa.

11. Procédé selon la revendication 10, **caractérisé en ce que** le revêtement est réalisé par un procédé de décharge en arc.

12. Procédé selon la revendication 10 ou 11, **caractérisé en ce que**, pendant la réalisation du revêtement, on amène un gaz inerte, en particulier de l'argon, sous une pression partielle de 0,1 Pa à 0,5 Pa.

13. Procédé selon l'une des revendications 10 à 12, **caractérisé en ce qu'**on utilise en tant que précurseur du CₓF_{y}, du SF₆ ou du CHFₓ.

14. Procédé selon l'une des revendications 10 à 13, **caractérisé en ce que** le gaz inerte et/ou le précurseur sont amenés grâce à un élément poreux, en particulier une cible poreuse en carbone.
